# EUROPÄISCHE PATENTANMELDUNG

(11) **EP 0 964 044 A1**
(43) Veröffentlichungstag der Anmeldung: **15.12.1999**
(21) Anmeldenummer: 99110393.8
(22) Anmeldetag: 28.05.1999
(51) Int. Cl.: C09K 11/06, H05B 33/14, C08G 61/02

(54) **Elektrolumineszierende Anordnungen unter Verwendung von Blendsystemen**

(30) Priorität: 09.06.1998 DE 19825765
(71) Anmelder: Bayer Aktiengesellschaft, 51368 Leverkusen (DE)
(72) Erfinder: Wehrmann, Rolf Dr., 47800 Krefeld (DE); Elschner, Andreas Dr., 45479 Mühlheim (DE); Thorn-Csanyi, Emma Prof.Dr., 22085 Hamburg (DE)

(57) **Zusammenfassung**

Elektrolumineszierende Anordnungen, enthaltend Oligomere von substituierten p-Divinylbenzolen der allgemeinen Formel (I) 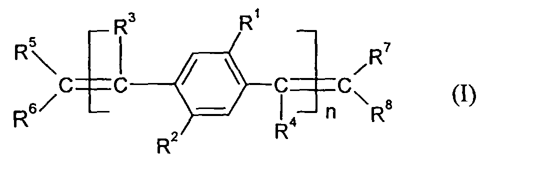 in welcher
- R^{¹} und R²: gleich oder verschieden sind und für lineares oder verzweigtes Alkyl oder Alkoxy mit 1 bis 12 C-Atomen, vorzugsweise 1 bis 8 C-Atome, im Falle der Verzweigung mit 3 bis 12, vorzugsweise 3 bis 8 C-Atomen stehen, Cycloalkyl mit 4 bis 10, vorzugsweise 5 oder 6 C-Atomen, oder
- R¹ oder R²: für Wasserstoff steht und der jeweils andere Rest R² oder R¹ die oben genannten Bedeutungen hat,
- R³ und R⁴: gleich oder verschieden sind und für Wasserstoff, C₁-C₆-Alkyl (vorzugsweise Methyl, Ethyl) CN oder Halogen (vorzugsweise Fluor, Chlor, Brom) stehen,
- R⁵, R⁶, R⁷ und R⁸: gleich oder verschieden sind und beliebige Reste sein können, u.a. Bausteine zur Kopplung der Oligomeren an andere Oligomere/Polymere,
- n: eine ganze Zahl von 2 bis 20, bevorzugt 2 bis 15 und besonders bevorzugt 2 bis 10 ist,
enthalten.

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-P 4 539 507, US-P 4 769 262, US-P 5 077 142, EP-A 406 762, EP-A 278 758, EP-A 278 757).

Weiterhin werden Polymere, wie Poly-(p-phenylene) und Poly-(p-phenylenvinylene (PPV)) als elektrolumineszierende Polymere beschrieben: G. Leising et al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 443 861, WO-A-9203490 und 92003491 beschrieben.

EP-A 0 294 061 stellt einen optischen Modulator auf Basis von Polyacetylen vor.

Zur Herstellung flexibler Polymer-LEDs haben Heeger at al. lösliche konjugierte PPV-Derivate vorgeschlagen (WO 92/16023).

Polymerblends unterschiedlicher Zusammensetzung sind ebenfalls bekannt: M. Stolka et al., Pure & Appt. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
- 1: Träger, Substrat
- 2: Basiselektrode
- 3: Löcher-injizierende Schicht
- 4: Löcher-transportierende Schicht
- 5: Licht-emittierende Schicht
- 6: Elektronen-transportierende Schicht
- 7: Elektronen-injizierende Schicht
- 8: Topelektrode
- 9: Kontakte
- 10: Umhüllung, Verkapselung.

Die Schichten 3 bis 7 stellen das elektrolumineszierende Element dar.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO 90/13148 aufder Basis von Poly-(p-phenylenvinylen) beschrieben.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings kann der Anlöseprozeß einer bereits aufgebrachten Schicht beim Überschichten mit der nächsten Schicht in bestimmten Fällen eine Schwierigkeit darstellen.

Die Aufgabe der vorliegenden Erfindung ist die Bereitstellung von elektrolumineszierenden Anordnungen mit hoher Leuchtdichte, wobei die aufzubringende Mischung gießbar, d.h. aus Lösung, aufgebracht werden kann.

Es wurde gefunden, daß elektrolumineszierende Anordnungen, die untengenanntes Blendsystem enthalten, diese Anforderungen erfüllen. Im folgenden ist der Begriff Zone auch mit Schicht gleichzusetzen.

Gegenstand der vorliegenden Erfindung sind daher elektrolumineszierende Anordnungen, enthaltend als elektrolumineszierendes Material A wenigstens ein Oligomeres von substituiertem p-Divinylbenzol mit der Wiederholungseinheit gemäß Formel (I) 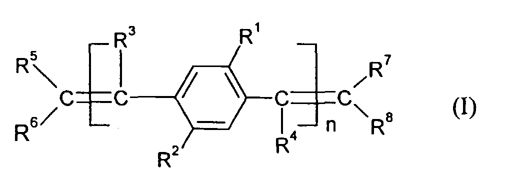 in welcher
- R¹ und R²: gleich oder verschieden sind und für jeweils lineares oder verzweigtes Alkyl oder Alkoxy mit 1 bis 12 C-Atomen, vorzugsweise 1 bis 8 C-Atome, im Falle der Verzweigung mit 3 bis 12, vorzugsweise 3 bis 8 C-Atomen oder Cycloalkyl mit 4 bis 10, vorzugsweise 5 oder 6 C-Atomen stehen, oder
- R^{¹} oder R²: für Wasserstoff steht und der jeweils andere Rest R² oder R¹ die oben genannten Bedeutungen hat,
- R³ und R⁴: gleich oder verschieden sind und für Wasserstoff, C₁-C₆-Alkyl (vorzugsweise Methyl, Ethyl) CN oder Halogen (vorzugsweise Fluor, Chlor, Brom) stehen,
- R⁵, R⁶, R⁷ und R⁸: gleich oder verschieden sind und beliebige Reste sein können, u.a. Bausteine zur Kopplung der Oligomeren an andere Oligomere/Polymere,
- n: eine ganze Zahl von 2 bis 20, bevorzugt 2 bis 15 und besonders bevorzugt 2 bis 10 ist.
- R⁵ und R⁷: stehen unabhängig voneinander vorzugsweise für Wasserstoff oder Alkyl, insbesondere C₁-C₄-Alkyl, ganz besonders bevorzugt Methyl,
- R⁶ und R⁸: stehen unabhängig voneinander vorzugsweise für Alkyl, insbesondere C₁-C₆-Alkyl, oder Aryl, insbesondere Phenyl, wobei Alkyl und Phenyl vorzugsweise eine oder mehrere funktionelle Gruppen, wie beispielsweise -OH, -CN, -CHO, Br aufweisen.

Die Oliogomere von substituiertem Divinylbenzol können bei geeigneter Substitution auch über funktionelle Gruppen z.B. in Polymere eingebaut werden. Dabei ist es möglich, sowohl Hauptketten - als auch Seitenkettenpolymere, die die niedermolekularen Verbindungen enthalten, herzustellen.

Die Ankoppelung der Oligomere an Polymere, die Doppelbindungen enthalten, z.B. ungesättigte Polymere wie Polybutadien, Polyoctenamer, erfolgt durch metathetischen Einbau (Cross-Metathese-Reaktion der Oligomeren und einem ungesättigten Polymer).

Die elektrolumineszierende Anordnung ist aufgebaut aus einer Anode, einem elektrolumineszierenden Element und einer Kathode, wobei wenigstens eine der beiden Elektroden im sichtbaren Spektralbereich transparent ist. Das elektrolumineszierende Element enthält:

Eine lochinjizierende Zone, lochtransportierende Zone, elektrolumineszierende Zone, elektronentransportierende Zone und/oder eine elektroneninjizierende Zone, dadurch gekennzeichnet, daß das elektrolumineszierende Element gegebenenfalls eine funktionalisierte Verbindung aus der Gruppe der lochtransportierenden Materialien, ein lumineszierendes Material A und gegebenenfalls Elektronentransportmaterialien enthält, wobei mindestens eine Zone vorhanden ist, einzelne Zonen weggelassen werden und die verbundene(n) Zone(n) mehrere Aufgaben übernehmen können.

Eine Zone kann mehrere Aufgaben übernehmen, d.h. daß eine Zone z.B. lochinjizierende, lochtransportierende, elektrolumineszierende, elektroneninjizierende und/oder elektronentransportierende Substanzen enthalten kann.

Das elektrolumineszierende Element kann ferner einen oder mehrere transparente polymere Binder B enthalten.

Die Oligomere von substituiertem p-Divinylbenzol können nach bekannten Verfahren hergestellt werden, beispielsweise durch Metathesereaktionen, die in Macromol. Rapid Commum. 16 (1995) 149 beschrieben sind, vgl. auch Beispiele.

Die Produkte sind in gängigen Lösemitteln löslich. Sie lassen sich zu transparenten Filmen verarbeiten, die - abhängig vom Wert n und/oder der Wahl der Substituenten am Phenylring unterschiedliche Photolumineszenz zeigen. Durch die Variation von n und/oder Wahl der Substituenten kann daher gezielt die Wellenlänge (Farbe) des emittierten Lichtes eingestellt werden.

Der Binder B steht für Polymere und/oder Copolymere wie z.B. Polycarbonate, Polyestercarbonate, Copolymere des Styrols wie SAN oder Styrolacrylate, Polysulfone, Polymerisate auf Basis von Vinylgruppen-haltigen Monomeren wie z.B. Poly(meth)acrylate, Polyvinylpyrrolidon, Polyvinylcarbazol, Vinylacetat- und Vinylalkoholpolymere und -copolymere, Polyolefine, cyclische Olefincopolymere, Phenoxyharze usw. Es können auch Mischungen verschiedener Polymere eingesetzt werden. Die polymeren Binder B weisen Molekulargewichte von 10 000 bis 200 000 g/mol auf, sind löslich und filmbildend und sind im sichtbaren Spektralbereich transparent. Sie sind z.B. beschrieben in Encyclopedia of Polymer Science and Engineering, 2^{nd} Ed. bei A. Wiley-Intersciencepublication. Das elektrolumineszierende Material A kann in den transparenten Binden B diepergiert werden. Die Konzentrationsverhältnisse sind beliebig variierbar. Sie werden üblicherweise in einer Menge bis zu 95, vorzugsweise bis zu 80 Gew.-%, bezogen auf das Gesamtgewicht aus A und B eingesetzt.

Zur Herstellung der Schicht werden die Komponenten A), und gegebenenfalls B) in einem geeigneten Lösemittel gelöst und durch Gießen, Rakeln oder Spincoating auf eine geeignete Unterlage aufgebracht. Dabei kann es sich z.B. um Glas oder ein Kunststoffmaterial handeln, das mit einer transparenten Elektrode versehen ist. Als Kunststoffmaterial kann z.B. eine Folie aus Polycarbonat, Polyester wie Polyethylenterephthalat oder Polyethylennaphthalat, Polysulfon oder Polyimid eingesetzt werden.

Als transparente Elektroden sind geeignet
a) Metalloxide, z.B. Indium-Zinn-Oxid (ITO), Zinnoxid (NESA), Zinkoxid, dotiertes Zinnoxid, dotiertes Zinkoxid, etc.,
b) semi-transparente Metallfilme, z.B. Au, Pt, Ag, Cu etc.,
c) leitfähige Polymerfilme wie Polyaniline, Polythiophene, etc.,

Die Metalloxid- und die semitransparenten Metallfilmelektroden werden durch Techniken wie Aufdampfen, Aufsputtern, Platinierung, etc., in dünner Schicht aufgebracht. Die leitfähigen Polymerfilme werden durch Techniken wie Spincoating, Casting, Rakeln etc. aus der Lösung aufgebracht.

Die Dicke der transparenten Elektrode beträgt 3 nm bis etwa mehrere µm, vorzugsweise 10 nm bis 500 nm.

Die elektrolumineszierende Schicht wird direkt auf die transparente Elektrode oder auf eine gegebenenfalls vorhandene ladungstransportierende Schicht als dünner Film aufgebracht. Die Dicke des Films beträgt 10 bis 500 nm, vorzugsweise 20 bis 400 nm, besonders bevorzugt 50 bis 250 nm.

Auf die elektrolumineszierende Schicht kann eine weitere ladungstransportierende Schicht eingefügt werden, bevor eine Gegenelektrode aufgebracht wird.

Eine Zusammenstellung von geeigneten ladungstransportierenden Zwischenschichten, bei denen es sich um loch- und/oder elektronenleitenden Materialien handeln kann, die in polymerer oder niedermolekularer Form gegebenenfalls als Blend vorliegen können, ist in EP-A 532 798 aufgeführt. Besonders geeignet sind speziell substituierte Polythiophene, die über lochtransportierende Eigenschaften verfügen. Sie sind beispielsweise in EP-A 686 662 beschrieben.

Der Gehalt an niedermolekularem Lochleiter in einem polymeren Binder ist im Bereich von 2 bis 97 Gew.-% variierbar; bevorzugt beträgt der Gehalt 5 bis 95 Gew.-%, besonders bevorzugt 10 bis 90 Gew.-%, insbesondere 10 bis 85 Gew.-%. Die lochinjizierenden bzw. lochleitenden Zonen können mit verschiedenen Methoden deponiert werden.

Filmbildende Lochleiter können auch in reiner Form (100 %ig) eingesetzt werden. Gegebenenfalls kann auch die lochinjizierende bzw. lochleitende Zone Anteile einer elektrolumineszierenden Substanz enthalten.

Blends, die ausschließlich aus Oligomeren von substituierten Divinylbenzol bestehen, können aufgedampft werden; lösliche und filmbildende Blends, die neben niedermolekularen Verbindungen auch einen Binder B) enthalten können (nicht notwendigerweise), können aus einer Lösung z.B. mittels Spincoating, Gießen, Rakeln deponiert werden.

Es ist auch möglich, emittierende und/oder elektronenleitende Substanzen in einer separaten Schicht auf die lochleitende Schicht mit der Komponente A aufzubringen. Dabei kann eine emittierende Substanz auch der die Verbindung A enthaltenden Schicht zudotiert ("Dopant") und zusätzlich eine elektronenleitende Substanz aufgebracht werden. Eine elektrolumineszierende Substanz kann auch der elektroneninjizierenden bzw. elektronenleitenden Schicht zugesetzt werden.

Andererseits können die elektrolumineszierenden Materialien A) auch selbst als Dotierstoffe in elektrolumineszierenden Anordnungen eingesetzt werden.

Der Gehalt an niedermolekularen Elektronenleitern im polymeren Binder ist im Bereich von 2 bis 95 Gew.-% variierbar; bevorzugt beträgt der Gehalt 5 bis 90 Gew.-%, besonders bevorzugt 10 bis 85 Gew.-%. Filmbildende Elektronenleiter können auch in reiner Form (100 %ig) eingesetzt werden.

Die Gegenelektrode besteht aus einer leitfähigen Substanz, die transparent sein kann. Vorzugsweise eignen sich Metalle, z.B. Al, Au, Ag, Mg, In, etc. oder Legierungen und Oxide dieser, die durch Techniken wie Aufdampfen, Aufsputtern, Platinierung aufgebracht werden können.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 0,1 bis 100 Volt Licht der Wellenlänge von 200 bis 2000 nm. Sie zeigen im Bereich von 200 bis 2000 in Photolumineszenz.

Die erfindungsgemäßen Anordnungen sind zur Herstellung von Einheiten zur Beleuchtung und zur Informationsdarstellung geeignet.

### Beispiele

### 1. Metathetische Darstellung von ringsubstituierten p-Phenylenvinylen-Oligomeren (und Polymeren)

Ausgehend von einem 2,5-ringsubstituierten 1,4-Bis-alken-1-yl-benzol, wie z.B. 1,4-Divinyl-benzol, 1,4-Dipropen-1-yl-benzol, 1,4-Diisobuten-1-yl-benzol usw. und unter Zusatz eines metatheseaktiven Katalysators, wie z.B. Mo(NAr^{Me2})(CHCMe₂Ph)[OCMe(CF₃)₂]₂ erfolgt die Oligomerisation (metathetische Polykondensation) durch Abspaltung und Entfernung eines niedermolekularen Monoolefins, wie z.B. Ethen, 2-Buten, 3-Hexen usw. Im Schema 1 ist die Reaktionsgleichung für die metathetische Umsetzung vom 2,5-disubstituierten 1,4-Divinylbenzol dargestellt.

Mo(NAr^{Me2})(CHCMe₂Ph)[OCMe(CF₃)₂]₂ die Synthese erfolgt nach der Literaturvorschrift R.R. Schrock, J.S. Murdzek, G.C. Bazan, J. Robbins, M. DiMare, M. O'Regan, J. Chem. Soc. 112 (1990) 3875. 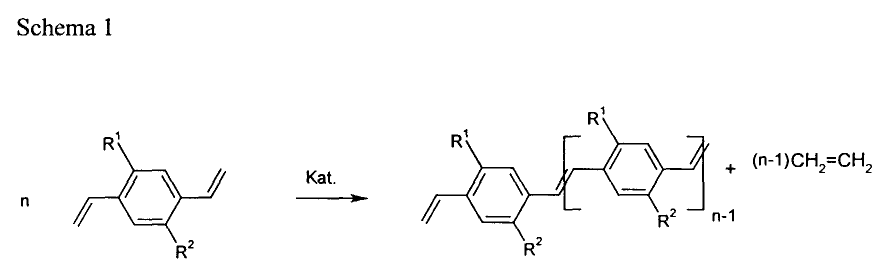 R¹ und R² entsprechen einem Alkyl- oder Alkoxy-Substituenten.

Die Polykondensationsreaktionen werden unter Inertgasstrom durchgeführt, verwendet wird Argon, das mittels eines Kleinabsorbers 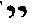 Oxisorb^{R}" (Fa. Messer-Grießheim, Duisburg, Deutschland) von Sauerstoff- und Wasserspuren befreit wird (<10⁻⁵ Vol.-%). Als Reaktionsgefäß dient ein Schlenkrohr oder ein Kolben, versehen mit Inertgas- und Vakuumanschluß (Standard Schlenk-Technik).

Die Glasgeräte werden vor Benutzung ca. 4 Stunden unter Quecksilber - Diffusionspumpenvakuum ausgeheizt und anschließend mit Argon gefüllt.

Die Lösemittel Toluol, Dekalin, Cyclohexan, Hexan, Pentan werden über Lithiumalanat 2 bis 3 Tage unter Rückfluß gekocht und unter Argon abdestilliert. Anschließend werden 250 ml Lösemittel mit 0,5 ml n-Butyllithium versetzt, bis zur Vakuumkonstanz (Quecksilber-Diffusionspumpenvakuum) mehreren Einfrier-/Auftau-Cyclen unterzogen und in ein Vorratsgefäß überkondensiert.

Die Polykondensation von dibutyl-, diheptyl- und didecyl-substituierten Divinylbenzolen und das Schützen (Cross-Metathese) der alkyl-substituierten p-Divinylbenzol-Oligomeren erfolgt bei Raumtemperatur. Die Umsetzung von dicyclohexyl- bzw. diheptyloxy-substituierten p-Divinylbenzolen erfolgt bei erhöhter Temperatur, bei 50°C bzw. 50 und 80°C.

### Synthese von Oligomeren des 2,5-diheptylsubstituierten 1,4-Divinylbenzols;

### a) Darstellung von Oligomeren mit enger Dispersität,

In einem Schutzgas- und Vakuum-Anschluß ausgerüsteten Schlenkrohr wird 68 mg (208 µmol) 2,5-Diheptyl-1,4-divinylbenzol als Feststoff vorgelegt und die Reaktion durch eine schnelle Zugabe der Katalysatorlösung (0,5 ml toluolische Lösung von Mo(NAr)(CHAr')[OC(CH₃)(CF₃)₂]₂) c = 6,7 mmol/L gestartet. Die Polykondensation erfolgt unter ständigem Rühren bei reduziertem Druck in geschlossener Apparatur. Durch mehrfaches kurzes Anlegen eines Unterdrucks an den Reaktionskolben (ca. 3 Mal in der ersten Stunde, dann etwa alle 6 Stunden) wird Ethen entfernt, um das Gleichgewicht der Reaktion auf die Seite des Polykondensats zu verschieben.

Nach einer Reaktionsdauer von 24 Stunden wird der Versuch durch Zugabe von Propanal beendet. Propanal erlaubt über eine Wittig-analoge Reaktion den definierten Abbruch der Metathesereaktion. Der Reaktionsansatz wird in 30 ml Toluol aufgenommen und anschließend filtriert. Das Produkt erhält man durch Ausfällen in 100 ml Methanol nach Filtration, Trocknung und Extraktion durch Chloroform.

Das isolierte Produkt zeigt eine enge Molekulargewichtsverteilung (GPC). Die Kettenlänge betrug 10 bis 11 (¹H-NMR; n = Anzahl α-Methylenprotonen/Anzahl Vinylprotonen),
¹H-NMR (100 MHz, CDCl₃)
   δ (ppm) = 7,43 (Ar-H); 7,23 (Ar-CH=CH-Ar, trans Vinylen); 6,97 (Ar-CH=CH₂); 5,67 (trans-vinylisches Endgruppenproton); 5,26 (cis-vinylisches Endgruppenproton); 2,75 (α-CH₂); 1,10-1,70 (β-ξ-CH₂), 0,89 -CH₃
UV/Vis (in THF)
λ (nm) = 395

### b) Darstellung von Oligomeren mit breiter Molekulargewichtsverteilung

2 g (6,12 mmol) 2,5-Diheptyl-1,4-divinylbenzol werden in einem mit Inertgas- und Vakuumanschluß ausgerüsteten Kolben mehrere Stunden am Quecksilberdiffusionspumpen-Vakuum getrocknet. Anschließend erfolgt die Zugabe von 50 ml Pentan und von 0,123 mmol Katalysator gelöst in 17 ml Pentan (c = 7,22 mmol/L). Der Reaktionsansatz wird nach Anlegen eines leichten Vakuums 24 Stunden bei Raumtemperatur unter Inertgasatmosphäre gerührt. Nach Zugabe von 3 ml Propionaldehyd wird das Lösungsmittel am Rotationsverdampfer entfernt, das Rohprodukt in Toluol aufgenommen und die höhermolekulare Oligomer-Fraktion durch Zugabe des doppelten Volumens Methanol ausgefällt. Dieses Produkt wird abfiltriert und am Ölpumpenvakuum (= 10⁻² bar) 10 Stunden vorgetrocknet und anschließend weitere 10 Stunden an dem Quecksilberdiffusionspumpen-Vakuum getrocknet. Es werden 1,05 g (56 %) Oligomeres mit einem mittleren Polymerisationsgrad von 6 bis 7 als grüner, fluoreszierender Feststoff erhalten.

### Produktcharakterisierung:

¹H-NMR (CDCl₃, 100 Mhz)
   δ (ppm) = 7,42 (Ar-H); 7,23 (Ar-CH=CH-Ar, trans Vinylen); 6,95 (Ar-CH=CH₂); 5,67 (trans-vinylisches Endgruppenproton); 5,27 (cis-vinylisches Endgruppenproton); 2,76 (α-CH₂); 1,10 - 1,70 (β-ξ-CH₂-); 0,88 -CH₃
UV-Vis (in THF)
λ (nm) = 390 (π-π*)

### c) Schützen der dargestellten Oligomeren; Crossmetathese mit trans-3-Hexen, d.h. z.B.: R₅ und R₇ = H und R₆ und R₈ = Ethyl.

Die Cross-Metatheseversuche werden im Lösemittel Toluol durchgeführt. Eingesetzt werden die in Hexan dargestellten substituierten Divinylbenzol-Oligomere.

Katalysator: Oligomer: trans-3-Hexen = 1:10:300, die Katalysator-Konzentration beträgt 1 mmol/L.

Die Reaktion wird bei Raumtemperatur durchgeführt und nach einem Tag durch Zugabe von Propanal abgebrochen. Lösemittel und flüchtige Substanzen werden mittels Ölpumpenvakuum entfernt. Anschließend wird der Rückstand in Toluol aufgenommen und die Lösung über einen Papierfilter in ein Fällungsbad (Methanol) eingetropft. Das Produkt wird mittels eines Büchnertrichters gewonnen und am Quecksilber-Diffüsionspumpenvakuum von haftenden Lösemittelresten befreit.

Die Aufarbeitung entsprach der der ungeschützten substituierten Divinylbenzol-Oligomeren.

Das Schützen der endständigen Vinyl-Doppelbindungen verläuft quantitativ und hochselektiv. Die Produktcharakterisierung erfolgt anhand ¹H-NMR-, UV/Vis-IR-, DSC- und GPC-Untersuchungen, im Falle des geschützten Monomers (n = 1) zusätzlich mit Hilfe der Gaschromatographie.

### 2. Aufbau der elektrolumineszierenden Anordnungen

In den nachfolgend beschriebenen Beispielen wird jeweils eine mit ITO (Indium-Zinn-Oxid) beschichtete Glasplatte (Baltracon 255 der Firma Balzers), die zusätzlich mit einer etwa 30 bis 50 nm dicken Schicht Baytron^{R} (PEPT/PSS, Polythiophen der Firma Bayer AG, Leverkusen, Deutschland) auf der ITO-Oberfläche versehen ist, eingesetzt. Als elektrolumineszierendes Material wird das 2,5-Diheptyl-1,4-divinylbenzol-Oligomer mit n = 6-7 Endgruppe: = CH-CH₂-CH₃, d.h. R₅ und R₇ = H und R₆ und R₈ = Ethyl verwendet.
a) Eine 1,5 %ige Lösung aus Luvican EP (Polyvinylcarbazol PVK, BASF AG, Ludwigshafen, Deutschland) und dem 2,5-Diheptyl-1,4-divenylbenzol-Oligomeren (n = 6-7) in Chloroform wird auf einem handelsüblichen Spincoater mit einer Umdrehungszahl von 400 min auf einem ITO/PEDT/PVK-Substrat verteilt. Die Schichtdicke beträgt 100 nm. Als Gegenelektrode wird Aluminium aufgedampft.
   Nach Kontaktierung und Anlegen eines elektrischen Feldes zeigt die Anordnung als etwa 6V visuell erkennbare Elektrolumineszenz im blauen Spektralbereich.
b) Der unter a) beschriebene Aufbau wird erweitert, indem auf die Schicht aus PVK eine 30 nm dicke Schicht Aluminiumoxin (Alq₃) aufgedampft wird.
   Nach Kontaktierung und Anlegen eines elektrischen Feldes zeigt die Anordnung als etwa 6V visuell erkennbare Elektrolumineszenz im grünen Spektralbereich.
c) Der Aufbau erfolgt analog b) mit dem Unterschied, daß PVK durch Polystyrol ersetzt wird.
   Nach Kontaktierung und Anlegen eines elektrischen Feldes zeigt die Anordnung ab etwa 6V visuell erkennbare Elektrolumineszenz im grünen Spektralbereich.

## Patentansprüche

1. Elektrolumineszierende Anordnungen, enthaltend wenigstens ein Oligomeres von substituiertem p-Divinylbenzol der allgemeinen Formel (I) 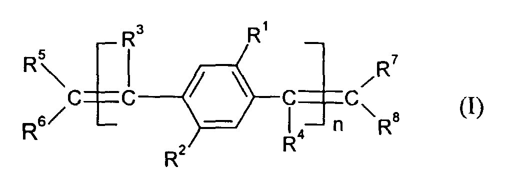 in welcher
R¹ und R² gleich oder verschieden sind und für lineares oder verzweigtes Alkyl oder Alkoxy mit 1 bis 12 C-Atomen, im Falle der Verzweigung mit 3 bis 12 C-Atomen oder Cycloalkyl mit 4 bis 10 C-Atomen stehen, oder
R¹ oder R² für Wasserstoff steht und der jeweils andere Rest R² oder R¹ die oben genannten Bedeutung hat,
R³ und R⁴ gleich oder verschieden sind und für Wasserstoff, C₁-C₆-Alkyl, CN oder Halogen stehen,
R⁵, R⁶, R⁷ und R⁸ gleich oder verschieden sind und beliebige Reste sein können,
n eine ganze Zahl von 2 bis 20 ist.

2. Elektrolumineszierende Anordnungen gemäß Anspruch 1, worin R⁵, R⁶, R⁷ und R⁸ gleich oder verschieden sind und als Reste Bausteine zur Kopplung der Oligomeren an andere Oligomere/Polymere darstellen.

3. Elektrolumineszierende Anordnungen gemäß Anspruch 1, worin R⁵, R⁶ und R⁷ unabhängig voneinander für Wasserstoff oder Alkyl und R⁶ und R⁸ unabhängig voneinander für Alkyl, Aryl, die gegebenenfalls eine oder mehrere funktionelle Gruppen enthalten, darstellen.

4. Verwendung der elektrolumineszierenden Anordnung gemäß Anspruch 1 für Be- und Hinterleuchtungszwecke oder zur Informationsdarstellung.

5. Verwendung der Oligomere von substituierten p-Divinylbenzolen gemäß Anspruch 1 zur Ankopplung an Oligomere oder Polymere.

6. Oligomere und Polymere, enthaltend Oligomere von substituierten p-Divinylbenzolen gemäß Anspruch 1 in der Haupt- und/oder Seitenkette.
